(19) Europäisches Patentamt
European Patent Office
Office européen des brevets

(11) Publication number: **0 023 610**
**B1**

(12) **EUROPEAN PATENT SPECIFICATION**

(45) Date of publication of patent specification: 15.02.84

(51) Int. Cl.³: C 08 G 73/14, C 08 G 73/12, H 01 B 3/30

(21) Application number: 80104023.9

(22) Date of filing: 11.07.80

(54) **A modified polyamide imide resin and its use for preparing electrical insulation materials and shaped articles.**

(30) Priority: 13.07.79 JP 89626/79

(43) Date of publication of application:
11.02.81 Bulletin 81/6

(45) Publication of the grant of the patent:
15.02.84 Bulletin 84/7

(84) Designated Contracting States:
DE FR GB

(56) References cited:
DE - A - 2 120 021
DE - A - 2 362 474
DE - A - 2 849 981

(73) Proprietor: KANEGAFUCHI KAGAKU KOGYO KABUSHIKI KAISHA
2-4 Nakanoshima 3-chome
Kita-ku Osaka-shi (JP)

(72) Inventor: Yonezawa, Kazuya
11-9, 4-chome, Kimikage-cho Kita-ku
Kobe-shi Hyogo (JP)
Inventor: Kira, Kazuaki
12-33-1303, 1-chome, Ryugadai Suma-ku
Kobe-shi Hyogo (JP)
Inventor: Wakabayashi, Hiroshi
5-26, 1-chome, Takamaru Tarumi-ku
Kobe-shi Hyogo (JP)
Inventor: Nagano, Hirosaku
96-1, Takigahira Shioya-cho Tarumi-ku
Kobe-shi Hyogo (JP)

(74) Representative: Vossius Vossius Tauchner Heunemann Rauh
Siebertstrasse 4 P.O. Box 86 07 67
D-8000 München 86 (DE)

EP 0 023 610 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# A modified polyamide imide resin and its use for preparing electrical insulation materials and shaped articles

This invention relates to modified imide resins with improved heat resistance and/or flexural strength.

The conventional known polyamide imide resins exhibit excellent electrical characteristics, heat resistance and mechanical properties and are therefore used for electrical insulating varnishes and heat resistant films and sheets. It is desired that films of sheet for printed circuit boards, for example, be capable of withstanding a soldering bath at 260 to 280°C. The polyamide imide resins commercially available at present still have to be improved as to heat resistance in such a soldering bath.

It is therefore an object of this invention to provide modified polyamide imide resins having improved heat resistance and/or flexural strength.

It has been found that when a polyamide imide resin containing in its molecule at least four carboxyl groups is reacted with an N-methylolated methacryl- or acryl-amide or derivatives thereof, the resulting resin shows improved heat resistance while retaining the desired electrical characteristics and gives films and sheets or sheeting or boards which have enhanced flexural strength. Based on this finding, the present invention has been accomplished. Although it appears useful to use severe curing temperatures for imparting improved heat resistance to polyamide imide resins containing carboxyl groups, we have found that the carboxyl groups then undergo a condensation reaction with the hydrogen atoms at the nitrogen atom of the intermolecular amide linkages, whereby the crosslinked portion is increased thus seriously impairing flexural strength of films or sheetings prepared therefrom. However, the carboxyl groups, when condensed with N-methylolated methacryl- or acryl-amide, permit the highly reactive acryloyl groups to cross-link with each other more easily without entailing a reduction in the molecular weight of the cross linked portion. This makes it possible to impart improved heat resistance to the resin without deteriorating its flexural strength.

Although DE—A—2 849 981 has disclosed how to react the end groups of a polyamide imide with e.g. acrylic acid, this document also contains an indication (page 17, paragraph 2) that leads away from the idea to modify side groups of a polyamide imide.

Accordingly the invention concerns to a modified polyamide imide resin containing in its molecule at least four carboxyl groups which are reacted with an N-methylolated methacryl- or acryl-amide or a derivative thereof in an amount of 1.0 to 5.0 mole equivalent weights per mole equivalent weight of the carboxyl groups.

According to the invention, useful polyamide imide resins are those having at least four carboxyl groups in their molecule. Such resins can be prepared by various processes. Among the polyamide imides prepared from polybasic acid anhydrides and diisocyanates, those produced from atomatic polybasic acid anhydrides and aromatic diisocyanates are preferred especially for ensuring improved heat resistance. For example, a suitable resin can be prepared by reacting excess trimellitic anhydride with an aromatic diisocyanate at 50 to 200°C for several hours. In this case, it is preferred to use 1.0 to 1.2 moles of trimellitic anhydride per mole of the diisocyanate. Although a larger amount of the acid anhydride can be used the use of a large excess of the anhydride gives a polyamide imide resin of low molecular weight only which is not strong enough to be used as a film or sheeting. Furthermore, in such a case it is possible to introduce carboxyl groups into the polyamide imide resin by reacting excess trimellitic anhydride or pyromellitic anhydride with a polyamide imide having a terminal isocyanate group and prepared by the process disclosed in Published Examined Japanese Patent Application No. 16080/1967.

In the preparation of polyamide imide resins having carboxylic groups, it is generally convenient to use a mixture of an aromatic diisocyanate as diisocyanate and an aromatic tribasic acid anhydride as polybasic acid anhydride. If desired, this mixture may also contain an aromatic tetrabasic acid anhydride as further polybasic acid anhydride. This yields resins having good heat resistance.

Examples of useful aromatic diisocyanates are tolylene diisocyanate, diphenylmethane diisocyanate, diphenylether diisocyanate, etc., which are used alone or in admixture. Examples of useful aromatic polybasic acid anhydrides are trimellitic anhydride, pyromellitic anhydride, benzophenone-tetracarboxylic anhydride. Since the use of at least 50 mole % of trimellitic anhydride affords good results as regards solubility of the polyamide imide resins, it is preferred to use the tetracarboxylic acid anhydride, preferably pyromellitic anhydride or benzophenone-tetracarboxylic anhydride in an amount of up to 50 mole %, more preferably of 0 to 40 mole %, based on the total polybasic acid anhydride employed. The polycondensation reaction is conducted in the presence of a solvent. Examples of useful solvents are dimethylformamide, dimethylacetamide, dimethyl sulfoxide, hexamethylphosphoric amide, N-methyl-pyrrolidone and similar aprotic polar solvents. These solvents can be used alone or in admixture. Aromatic hydrocarbons and ketones can also be used together with such solvents insofar as the polyamide imide resin does not precipitate.

The polycondensation reaction is preferably carried out at a temperature of 50 to 200°C, more preferably at 100 to 180°C. The carboxyl groups in the resulting polyamide imide resins are quantitatively determined by potentiometric titration with sodium methylate.

The polyamide imide resins thus obtained contain at least four carboxyl groups per molecule.

Although resins containing a smaller number of carboxyl groups could be used they will not be modified effectively with N-methylolated methacryl- or acryl-amides or derivatives thereof.

The N-methylolated methacryl- or acryl-amide or derivative thereof are used in an amount of about 1.0 to about 5.0 mole equivalent weights, more preferably of about 1.0 to about 2.0 mole equivalent weights, per mole equivalent weight of carboxyl groups.

Examples of useful amides are N-methylolated acrylamide, N-alkoxymethyl acrylamides, preferably n-alkoxy ($C_1$ to $C_4$) methyl acrylamides such as N-methoxymethyl acrylamide, N-ethoxymethyl acrylamide, N-propoxymethyl acrylamide, and N-butoxymethyl acrylamide, and N-methylolated methacrylamide, N-alkoxymethyl methacrylamides, preferably N-alkoxy ($C_1$ to $C_4$) methyl methacrylamide such as N-methoxymethyl methacrylamide, N-ethoxymethyl methacrylamide N-propoxymethyl methacrylamide, and N-butoxymethyl methacrylamide.

These compounds can be used alone or in admixture. The combined amount of the compounds however should not exceed 5 mole equivalent weights per mole equivalent weight of the carboxyl groups. Should these amide compounds be used in excessive amounts, the films obtained would have low heat resistance and poor flexural strength.

For preparing the modified polyamide imide resins of the invention the polyamide imide having carboxyl groups is reacted with an N-methylolated methacryl- or acryl-amide or a derivative thereof at a temperature of 50 to 200°C, preferably 100 to 150°C for 0.5 to 3 hours. At high temperatures, such amide compounds in the reaction system are likely to polymerize. Satisfactory results can be achieved if the reaction is effected in the presence of 5 to 200 ppm of a polymerization inhibitor such as butylated hydroxytoluene.

The modified polyamide imide resins obtained can be cured or polymerized by a radical mechanism and possess improved heat resistance and also enhanced flexural strength as compared with the original resin.

We have also found that modified polyamide imide resins of further improved heat resistance can be obtained by adding a bismaleimide compound. The bismaleimide compound is used in an amount of 5 to 50% by weight based on the polyamide imide resin. Less than 5% by weight of the bismaleimide would not result in sufficiently improved heat resistance, whereas the use of more than 50% by weight of the compound would give films of impaired flexural strength. The bismaleimide compound preferably has the formula

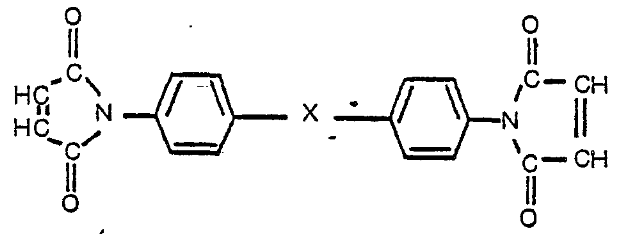

wherein X is $CH_2$, O, $SO_2$, S, or $C(CH_3)_2$.

The bismaleimide compounds can be used in admixture with the N-methylolated methacryl- or acryl-amides or derivatives thereof, and the polyamide imide resin to be modified, or can be added to the reaction mixture of polyamide imide resin modified with N-methylolated methacryl- or acryl-amide or a derivative. This finding has led to another feature of the invention.

The carbon-carbon double bond of the bismaleimide copolymerizes with the carbon-carbon double bond of the N-methylolated methacryl- or acryl-amide or derivative thereof. Films obtained from this resin are transparent and have outstanding heat resistance.

For the preparation of shaped articles such as films, sheetings or boards, azobisisobutyronitrile, azobisvaleronitrile or similar azo compounds, or di-tert.-butyl peroxide, benzoyl peroxide or similar peroxides can be added as radical initiators to the resins of the invention for curing or further polymerization. However, when films or sheetings are formed at a temperature not lower than 150°C, the shaped articles desired can be obtained merely be heating the resin in the absence of a radical initiator.

The modified polyamide imide resins of the invention may contain further additives, depending on the final use of the resins.

The invention will be described in detail with reference to the following examples, to which, however, the invention is not limited. The heat resistance was tested according to JIS—C—6481 and flexural strength according to JIS—P—8115.

Preparation of polyamide imide resin I

0.95 mole of diphenylmethane diisocyanate (MDI) and 1.00 mole of trimellitic anhydride were placed into a 2-liter three-necked flask. The air in the flask was replaced by nitrogen, and 1200 ml of N-methyl-2-pyrrolidone were charged into the flasks. The mixture was reacted at 100°C for 1.5 hours, at 130°C for 2 hours and further at 180°C for 6 hours under stirring.

The solution of the polyamide imide resin in N-methyl-2-pyrrolidone had a viscosity of 2 Pa s at room temperature and at a concentration of 22% by weight.

Preparation of polyamide imide resin II

1.02 mole of diphenylmethane diisocyanate and 1.00 mole of trimellitic anhydride were placed into a 2-liter three-necked flask. The air in the flask was replaced by nitrogen, and 1200 ml of N-methyl-2-pyrrolidone were charged into the flask. The mixture was reacted at 100°C for 1 hour, at 130°C for 2 hours and further at 180°C for 4 hours. Subsequently 0.04 mole of pyromellitic anhydride was added to the mixture, and the resulting mixture was reacted at 130°C for 2 hours.

A solution of the polyamide imide resin in N-methyl-2-pyrrolidone had a viscosity of 14 Pa s at room temperature and at a concentration of 23% by weight.

Examples 1—3

N-methylolated acrylamide was added to the solution of the polyamide imide resin I, and the mixture was treated in the presence of 10 ppm of BHT at 120°C for 1 hour and thereafter cooled.

Benzoyl peroxide (2% by weight) was added to the resulting mixture, and the resin solution obtained was applied to a glass plate. The coated plate was heated to 180—280°C over a period of 30 minutes to prepared a film.

In examples 2 and 3 the above procedure was repeated, respectively using the polyamide imide resin II solution and a commercial polyamide imide resin (trademark "HI—400", product of Hitachi Kasei Co., Ltd., Japan, having a viscosity of 6 Pa s at room temperature and at a concentration of 20% by weight.

The results are given in Table I, which also shows the properties of films produced from the resins I, II and HI—400.

The films were all 50 $\mu$m thick.

TABLE 1

| Resin | Carboxyl groups *1 | N-methylolated acrylamide *2 | Heat resistance *3 260°C | Heat resistance *3 280°C | Flexural strength |
|---|---|---|---|---|---|
| Polyamide imide resin I | About 25 | — | *c* | *c* | 15 |
| Example 1 | About 25 | About 1.2 | *a* | *b* | 28 |
| Polyamide imide resin II | About 16 | — | *b* | *c* | 25 |
| Example 2 | About 16 | About 1.1 | *a* | *a—b* | 38 |
| HI—400 | About 20 | — | *b* | *c* | 21 |
| Example 3 | About 20 | About 1.5 | *a* | *a—b* | 34 |

Note: *1 The number of carboxyl groups per unit of the polyamide imide.

*2 Mole equivalent weights per mole equivalent weight of carboxyl groups in the polyamide imide.

*3 The film was immersed in a soldering bath at 260°C or 280°C for 3 seconds. The mark "*a*" stands for no changes. "*b*" stands for a film with a partially uneven surface producing irregular light and shade patterns in some areas. "*c*" indicates a film with uneven surface overall resulting in irregular light and shade patterns throughout.

Examples 4—8

Bismaleimides were added to the composition of Example 2 and to the composition of Example 3 and were stirred at room temperature until they dissolved. From the resins obtained films were prepared in the same manner as above. The films were examined for heat resistance. The results are given in Table 2.

TABLE. 2

| Resin | Bismaleimide | Heat resistance 260°C | Heat resistance 280°C |
|---|---|---|---|
| Example 4 (Composition of Ex. 2) | A*4 17 wt. % | *a* | *a—b* |
| Example 5 (Composition of Ex. 2) | A 30 wt. % | *a* | *a* |
| Example 6 (Composition of Ex. 3) | A 30 wt. % | *a* | *a* |
| Example 7 (Composition of Ex. 2) | B*5 17 wt. % | *a* | *a—b* |
| Example 8 (Composition of Ex. 3) | B 17 wt. % | *a* | *a—b* |
| Blank HI—400 | — | *b* | *c* |

Note: *4 A is

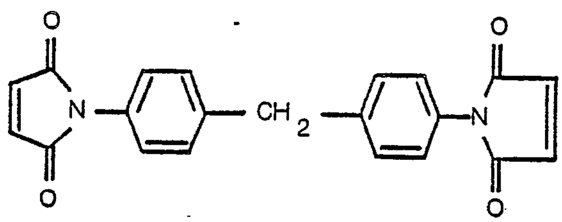

*5 B is

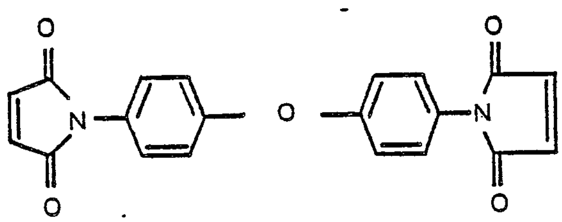

## Claims

1. A modified polyamide imide resin containing in its molecule at least four carboxyl groups which are reacted with an N-methylolated methacryl- or acryl-amide or a derivative thereof in an amount of 1.0 to 5.0 mole equivalent weights per mole equivalent weight of the carboxyl groups.

2. A modified polyamide imide resin as defined in claim 1 wherein the resin has been further modified with a bismaleimide compound in an amount of 5 to 50% by weight based on the polyamide imide resin.

3. A modified polyamide imide resin as defined in claim 2 wherein the bismaleimide compound is represented by the formula

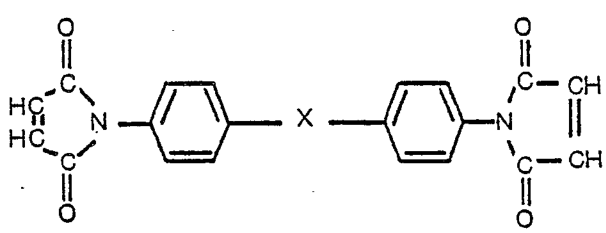

wherein X is $CH_2$, O, $SO_2$, S or $C(CH_3)_2$.

4. The use of the resins according to claims 1 to 3 for preparing electrical insulation materials and shaped articles.

**Patentansprüche**

1. Ein modifiziertes Polyamidimidharz, enthaltend in seinem Molekül mindestens vier Carboxylgruppen, die mit einem N-methyloliertem Methacryl- oder Acrylamid oder einem Derivat davon in einer Menge von 1,0 bis 5,0 Moläquivalentgewichten pro Moläquivalentgewicht der Carboxylgruppe umgesetzt sind.

2. Ein modifiziertes Polyamidimidharz gemäß Anspruch 1, wobei das Harz zusätzlich mit einer Bismaleimidverbindung in einer Menge von 5 bis 50 Gewichtsprozent, bezogen auf das Polyamidimidharz, modifiziert worden ist.

3. Ein modifiziertes Polyamidimidharz gemäß Anspruch 2, wobei die Bismaleimidverbindung durch die Formel

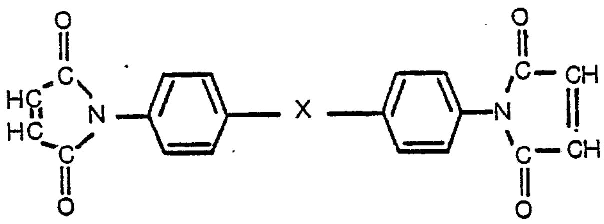

wiedergegeben wird, in der X $CH_2$, O, $SO_2$, S oder $C(CH_3)_2$ ist.

4. Verwendung der Harze nach den Ansprüchen 1 bis 3, zur Herstellung von elektrischem Isoliermaterial und Formteilen.

**Revendications**

1. Résine de polyamide imide modifiée contenant dans sa molécule au moins 4 groupes carboxy qui ont réagi avec un méthacryl- ou acryl-amide N-méthylolé ou un de leurs dérivés en une quantité de 1,0 à 5,0 équivalents molaires pondéraux par équivalent molaire pondéral des groupes carboxy.

2. Résine de polyamide imide modifiée selon la revendication 1, dans laquelle la résine a été de plus modifiée avec un composé de type bismaléimide en une quantité de 5 à 50% en poids par rapport à la résine de polyamide imide.

3. Résine de polyamide imide modifiée selon la revendication 2, dans laquelle le composé de type bismaléimide est représenté par la formule

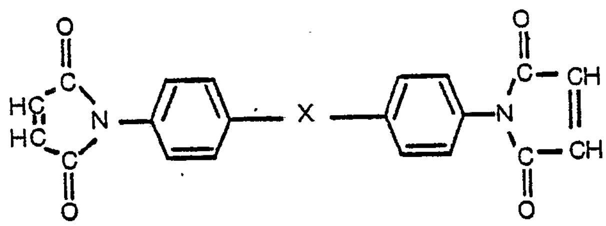

dans laquelle X est $CH_2$, O, $SO_2$, S ou $C(CH_3)_2$.

4. Utilisation des résines selon l'une des revendications 1 à 3, pour la préparation de matériaux d'isolation électrique et d'articles façonnés.